# EUROPÄISCHE PATENTSCHRIFT

(11) **EP 0 942 937 B1**
(45) Veröffentlichungstag und Bekanntmachung des Hinweises auf die Patenterteilung: **18.04.2001**
(21) Anmeldenummer: 97952778.5
(22) Anmeldetag: 18.11.1997
(51) Int. Cl.: C08F 2/50, G03F 7/029

(54) **PHOTOINITIATORGEMISCHE, ENTHALTEND ACYLPHOSPHINOXIDE UND BENZOPHENONDERIVATE**
PHOTOINITIATOR MIXTURES CONTAINING ACYLPHOSPHINOXIDES AND BENZOPHENONE DERIVATIVES
MELANGES DE PHOTOAMORCEURS CONTENANT DES OXYDES D'ACYLPHOSPHINE ET DES DERIVES DE BENZOPHENONE

(30) Priorität: 05.12.1996 DE 19650562
(43) Veröffentlichungstag der Anmeldung: 22.09.1999
(73) Patentinhaber: BASF AKTIENGESELLSCHAFT, 67056 Ludwigshafen (DE)
(72) Erfinder: BECK, Erich, D-68528 Ladenburg (DE); KANDZIA, Christof, D-67157 Wachenheim (DE); PRANTL, Bernhard, D-67549 Worms (DE); LOKAI, Matthias, D-67677 Enkenbach-Alsenborn (DE); ENENKEL, Peter, D-67258 He heim (DE); KEIL, Edmund, D-67259 Heuchelheim (DE); MENZEL, Klaus, D-71696 Möglingen (DE)
(86) Internationale Anmeldenummer: EP9706423
(87) Internationale Veröffentlichungsnummer: WO9828340

(56) Entgegenhaltungen:
- EP-A- 0 007 508
- EP-A- 0 073 413
- EP-A- 0 446 175
- EP-A- 0 513 781

## Beschreibung

Die Erfindung betrifft eine Photoinitiatormischung, enthaltend
a) mindestens ein Acyl- oder Diacylphosphinoxid der Formel I 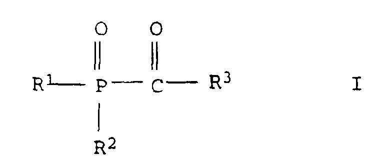 worin
   - R₁: C₁-C₁₈-Alkyl, durch Halogen oder C₁-C₆-Alkoxy substituiertes C₁-C₄-Alkyl, C₅-C₈-Cycloalkyl, C₇-C₉-Phenylalkyl, Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl, oder einen einwertigen N-, O- oder S-haltigen 5- oder 6-gliedrigen heterocyclischen Rest bedeutet,
   - R₂: Phenyl, Naphthyl, Biphenylyl durch Halogen, C₁-C₁₂-Alkyl und/oder C₁-C₁₂-Alkoxy ein- oder mehrfach substituiertes Phenyl, Naphthyl oder Biphenylyl, einen einwertigen N-, O- oder S-haltigen 5- oder 6-gliedrigen heterocyclischen Rest, C₁-C₁₈-Alkoxy, Phenoxy, durch Halogen, C₁-C₄-Alkyl oder C₁-C₄-Alkoxy substituiertes Phenoxy, Benzyloxy, Cyclohexyloxy oder eine Gruppe -CO-R₄ bedeutet, oder R₂ und R₁ zusammen mit dem Phosphoratom einen Ring bilden,
   - R₃: C₁-C₁₈-Alkyl, durch Halogen oder C₁-C₆-Alkoxy substituiertes C₁-C₄-Alkyl, C₅-C₈-Cycloalkyl, C₇-C₉-Phenylalkyl, Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl, einen einwertigen N-, O- oder S-haltigen 5- oder 6-gliedrigen heterocyclischen Rest oder eine Gruppe 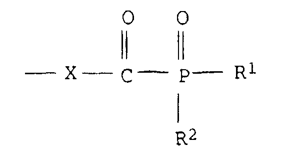 bedeutet, worin X C₂-C₈-Alkylen, Cyclohexylen oder unsubstituiertes oder durch Halogen, C₁-C₄-Alkyl oder C₁-C₄-Alkoxy substituiertes Phenylen oder Biphenylen bedeuten und
   - R⁴: C₁-C₁₈-Alkyl, durch Halogen oder C₁-C₄-Alkoxy substituiertes C₁-C₄-Alkyl, C₅-C₈-Cycloalkyl, C₇-C₉-Phenylalkyl, Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl oder einen einwertigen N-, O- oder S-haltigen 5- oder 6-gliedrigen heterocyclischen Rest bedeutet, oder R⁴ und R³ zusammen C₂-C₁₂-Alkylen, Vinylen oder o-Phenylen bedeuten,
   und
b) mindestens ein Benzophenonderivat der Formel 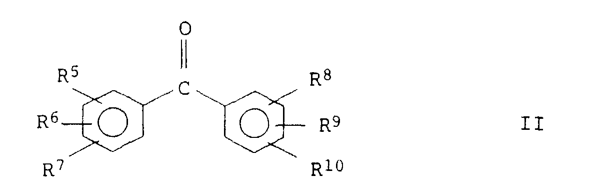 worin R⁵, R⁶ und R⁷ unabhängig voneinander C₁-C₁₂-Alkyl, C₁-C₄-Alkylthio, C₁-C₄-Alkoxy, Halogen oder C₂-C₆-Alkoxycarbonyl bedeuten und R⁸, R⁹ und R¹⁰ Wasserstoff, C₁-C₁₂-Alkyl, C₁-C₄-Alkoxy, Halogen oder C₂-C₆-Alkoxycarbonyl oder C₁-C₄-Alkylthio bedeuten
   oder ein Gemisch von Benzophenonderivaten der Formel II mit anderen Benzophenonderivaten.

Des weiteren betrifft die Erfindung strahlungshärtbare Massen, welche die Photoinitiatorgemische enthalten.

Acylphosphinoxide und ihre Verwendung als Photoinitiatoren sind z.B. aus EP-A-7508 oder EP-A-7086 bekannt.

Photoinitiatorgemische, enthaltend Acylphosphinoxide und Benzophenone, sind bereits in EP-A-446 175 beschrieben.

Aus EP-A-513781 sind flüssige Photoinitiatorgemische bekannt, welche Acylphosphinoxide enthalten.

An Photoinitiatoren, welche in strahlungshärtbaren Massen Verwendung finden, werden eine Vielzahl von Anforderungen gestellt. Von besonderer Bedeutung ist eine hohe Reaktivität der Photoinitiatoren, worunter zum einen eine schnelle Aushärtung zum anderen die Aushärtung auch von dicken Schichten bis in die unteren Lagen zu verstehen ist.

Nachteilig bei bisher bekannten strahlungshärtbaren Massen ist vielfach eine Inhibierung der Aushärtung durch Luftsauerstoff.

Anwendungstechnisch von Vorteil sind grundsätzlich flüssige Photoinitiatoren, die sich leichter mit den im allgemeinen flüssigen strahlungshärtbaren Verbindungen mischen lassen. Weiterhin sind Geruchsbelästigungen, wie sie bei bisher bekannten Photoinitiatoren oft auftreten, zu vermeiden.

Aufgabe der vorliegenden Erfindung waren daher Photoinitiatoren, welche die obigen Anforderungen in besonderem Maße erfüllen.

Demgemäß wurden die eingangs definierten Photoinitiatorgemische und ihre Verwendung in strahlungshärtbaren Massen gefunden.

Die erfindungsgemäße Photoinitiatormischung enthält mindestens ein Acyl- oder Diacylphosphinoxid der Formel I (Bestandteil a) der Mischung).

Die Reste R¹ bis R⁴ haben vorzugsweise folgende Bedeutung.
- R¹:: C₁-C₁₈-Alkyl; Phenyl; C₇-C₉-Phenylalkyl; durch Halogen, C₁-C₁₂-Alkyl und/oder C₁-C₁₂-Alkoxy einfach oder mehrfach substituiertes Phenyl
- R²:: C₁-C₁₈-Alkoxy; Phenoxy; durch Halogen, C₁-C₄-Alkyl oder C₁-C₄-Alkoxy substituiertes Phenoxy; Benzyloxy; Phenyl; durch Halogen, C₁-C₁₂-Alkyl und/oder C₁-C₁₂-Alkoxy ein oder mehrfach substituiertes Phenyl; 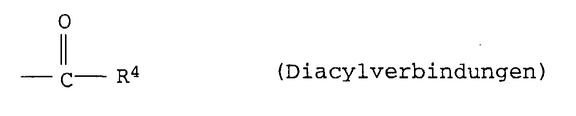
- R³:: C₁-C₁₈-Alkyl; C₇-C₉-Phenylalkyl; Phenyl; durch Halogen, C₁-C₁₂-Alkyl und/oder C₁-C₁₂-Alkoxy ein- oder mehrfach substituiertes Phenyl
- R⁴:: C₁-C₁₈-Alkyl; Phenyl; C₇-C₉-Phenylalkyl; durch Halogen, C₁-C₁₂-Alkyl und/oder C₁-C₁₂-Alkoxy einfach oder mehrfach substituiertes Phenyl

Besonders bevorzugt stehen R¹ bis R⁴ für:
- R¹:: Phenyl, C₂-C₁₂-Alkyl, z.B. Isoamyl
- R²:: Phenyl, Phenoxy, C₂-C₁₂-Alkoxy, insbesondere Ethoxy, n-Propoxy, iso-Propoxy, n-Butoxy, iso-Butoxy, Pentoxy, Cyclohexyloxy oder -CO-R⁴
- R³:: durch Halogen, C₁-C₁₂-Alkyl oder C₁-C₁₂-Alkoxy zweifach- oder dreifach substituiertes Phenyl, bevorzugt in 2,4-Stellung bzw. 2,4,6-Stellung. Besonders geeignete Reste R³ sind z.B. 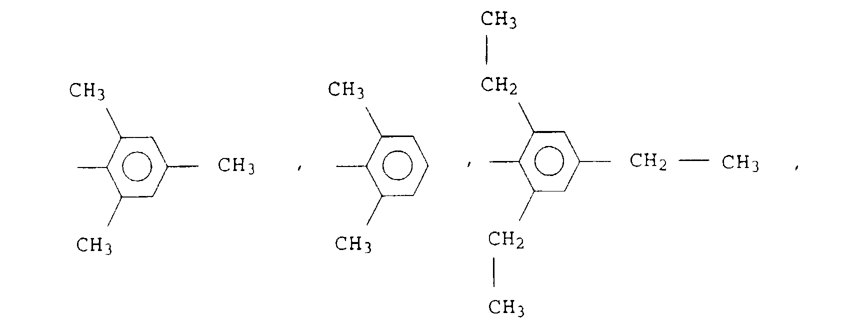 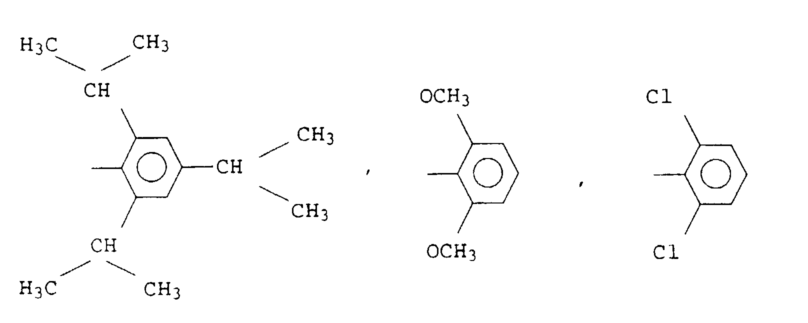
- R⁴:: wie R³

Bei Halogensubstituenten, welche vorstehend oder nachfolgend in dieser Anmeldung erwähnt sind, handelt es sich vorzugsweise um Cl oder Br, besonders bevorzugt um Cl.

Als ganz besonders bevorzugte Verbindungen seien aufgeführt: 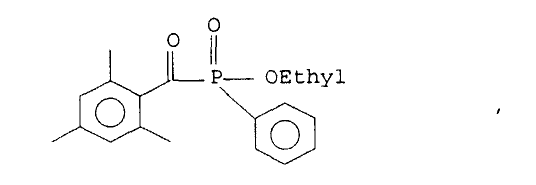 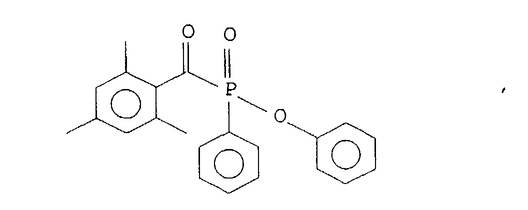 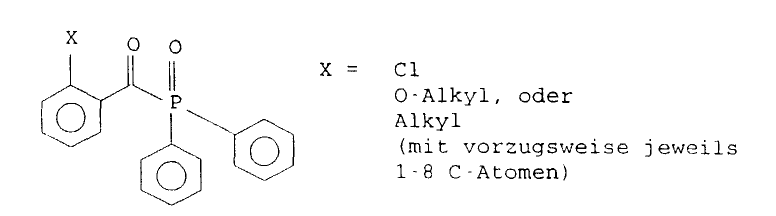 und insbesondere 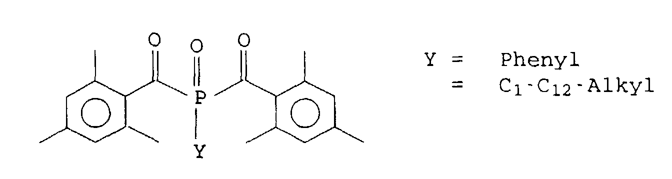 sowie 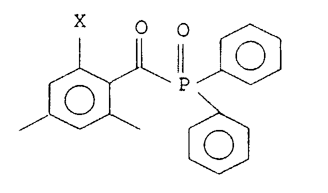 Beim Bestandteil b) der erfindungsgemäßen Mischung handelt es sich um ein Benzophenonderivat der Formel II oder ein Gemisch eines Benzophenonderivates der Formel II mit anderen Benzophenonderivaten.

Die Reste R⁵ bis R¹⁰ haben bevorzugt folgende Bedeutung
- R⁵,R⁶,R⁷:: unabhängig voneinander C₁-C₁₂-Alkyl, insbesondere C₁-C₄-Alkyl, besonders bevorzugt Methyl. Die Substitution ist bevorzugt in 2,4,6-Stellung (Substitution der Carbonylgruppe in 1-Stellung)
- R⁸,R⁹,R¹⁰:: unabhängig voneinander Wasserstoff oder C₁-C₁₂-Alkyl, insbesondere C₁-C₄-Alkyl, insbesondere C₁-C₄-Alkyl. Besonders bevorzugt stehen mindestens einer, vorzugsweise mindestens zwei der Reste R⁸, R⁹ und R¹⁰ für Wasserstoff und der oder die verbleibenden Reste für Wasserstoff oder C₁-C₄-Alkyl, insbesondere Methyl.

In einer bevorzugten Ausführungsform handelt es sich bei den Benzophenonderivaten b) um ein Gemisch der Benzophenonderivate der Formel II mit weiteren Benzophenonderivaten, insbesondere solchen der Formel III, 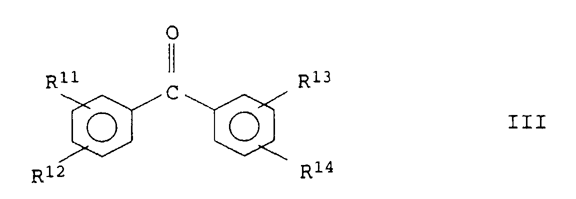 worin R¹¹, R¹², R¹³ und R¹⁴ unabhängig voneinander für Wasserstoff, C₁-C₁₂-Alkyl, C₁-C₄-Alkoxy, C₁-C₄-Alkylthio, Halogen oder C₂-C₆-Alkoxycarbonyl bedeuten.

Bevorzugt stehen R¹¹, R¹², R¹³ und R¹⁴ unabhängig voneinander für Wasserstoff oder C₁-C₁₂-, insbesondere C₁-C₄-Alkyl bzw. Methyl. Vorzugsweise stehen mindestens 2 der Reste R¹¹, R¹², R¹³, R¹⁴ für Wasserstoff und die verbleibenden Reste für Wasserstoff oder das vorstehende Alkyl.

Ein besonders bevorzugtes Gemisch von Benzophenonderivaten b) ist ein Gemisch aus 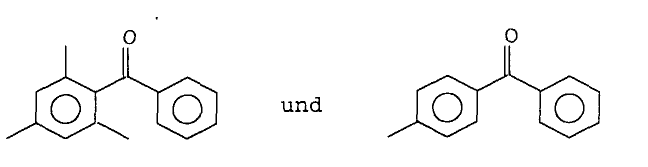 welches als TZT^{®} durch die Firma Fratelli Lamberti angeboten wird.

Das Gemisch der Benzophenonderivate b) besteht bevorzugt zu
- 10 bis 90: Gew.-%, besonders bevorzugt zu
- 50 bis 85: Gew.-% aus Benzophenonderivaten der Formel II und bevorzugt zu
- 90 bis 10: Gew.-%, besonders bevorzugt zu
- 15 bis 50: Gew.-% aus anderen Benzophenonderivaten, insbesondere Benzophenonderivate der Formel III, bezogen auf die Gesamtmenge der Benzophenonderivate b)

Bei den Benzophenonderivaten b) kann es sich auch um ein Gemisch aus 60 bis 95 Gew.-% Benzophenonderivate der Formel II und 5 bis 40 Gew.-% Benzophenonderivate der Formel III, bezogen auf die Gesamtmenge der Benzophenonderivate b) handeln.

Der Gehalt der Acryl- oder Diacylphosphinoxiden a) und der Benzophenonderivate b) beträgt vorzugsweise
- 0,5 bis 99,5: Gew.-%, besonders bevorzugt
- 0,5 bis 40: Gew.-% und ganz besonders bevorzugt
- 5 bis 30: Gew.-% Verbindung a) und
- 0,5 bis 99,5: Gew.-%, besonders bevorzugt
- 60 bis 99,5: Gew.-% und ganz besonders bevorzugt
- 70 bis 95: Gew.-% Verbindung b), bezogen auf die Summe aus a) + b).

Die Herstellung des erfindungsgemäßen Photoinitiatorgemisches kann in einfacher Weise durch Mischen der Verbindungen a) und b) in beliebiger Reihenfolge erfolgen.

Die erfindungsgemäße Photoinitiatormischung wird insbesondere als Photoinitiator für die Strahlungshärtung von radikalisch polymerisierbaren, ethylenisch ungesättigten Verbindungen verwendet.

Das Gemisch, welches die erfindungsgemäße Photoinitiatormischung und mindestens eine polymerisierbare, ethylenisch ungesättigte Verbindung enthält, wird im nachfolgenden auch strahlungshärtbare Masse genannt.

Als strahlungshärtbare, radikalisch polymerisierbare Verbindungen kommen Verbindungen mit nur einer ethylenisch ungesättigten, copolymerisierbaren Gruppe in Betracht (Verbindungen A).

Genannt seien z.B. C₁-C₂₀-Alkyl (meth) acrylate, Vinylaromaten mit bis zu 20 C-Atomen, Vinylester von bis zu 20 C-Atomen enthaltenden Carbonsäuren, ethylenisch ungesättigten Nitrile, Vinylether von 1 bis 10 C-Atome enthaltenden Alkoholen und aliphatischen Kohlenwasserstoffen mit 2 bis 8 C-Atomen und 1 oder 2 Doppelbindungen.

Als (Meth)acrylsäurealkylester bevorzugt sind solche mit einem C₁-C₁₀-Alkylrest, wie Methylmethacrylat, Methylacrylat, n-Butylacrylat, Ethylacrylat und 2-Ethylhexylacrylat.

Insbesondere sind auch Mischungen der (Meth)acrylsäurealkylester geeignet.

Vinylester von Carbonsäuren mit 1 bis 20 C-Atomen sind z.B. Vinyllaurat, -stearat, Vinylpropionat und Vinylacetat.

Als vinylaromatische Verbindungen kommen z.B. Vinyltoluol, α-Butylstyrol, 4-n-Butylstyrol, 4-n-Decylstyrol und vorzugsweise Styrol in Betracht.

Beispiele für Nitrile sind Acrylnitril und Methacrylnitril.

Geeignete Vinylether sind z.B. Vinylmethylether, Vinylisobutylether, Vinylhexyl- und -octylether.

Als nicht aromatische Kohlenwasserstoffe mit 2 bis 8 C-Atomen und eine oder zwei olefinischen Doppelbindungen seien Butadien, Isopren, sowie Ethylen, Propylen und Isobutylen genannt.

Bevorzugte strahlungshärtbare, radikalisch polymerisierbare Verbindungen sind solche mit mehreren polymerisierbaren, ethylenisch ungesättigten Gruppen (Verbindungen B).

Insbesondere handelt es sich bei Verbindungen B) um (Meth)acrylatverbindungen, bevorzugt sind jeweils die Acrylatverbindungen, d.h. die Derivate der Acrylsäure.

Bevorzugte (Meth)acrylat-Verbindungen B) enthalten 2 bis 20, bevorzugt 2 bis 10 und ganz besonders bevorzugt 2 bis 6 copolymerisierbare, ethylenisch ungesättigte Doppelbindungen.

Das zahlenmittlere Molekulargewicht Mₙ der (Meth)acrylatverbindungen B) liegt bevorzugt unter 15000, besonders bevorzugt unter 5000, ganz besonders bevorzugt unter 3000 g/mol und über 180 g/mol (bestimmt durch Gelpermeationschromatographie mit Polystyrol als Standard und Tetrahydrofuran als Elutionsmittel).

Als (Meth)acrylatverbindungen genannt seien (Meth) acrylsäureester und insbesondere Acrylsäureester von mehrfunktionellen Alkoholen, insbesondere solchen, die neben den Hydroxylgruppen keine weiteren funktionellen Gruppen oder allenfalls Ethergruppen enthalten. Beispiele solcher Alkohole sind z.B. bifunktionelle Alkohole, wie Ethylenglykol, Propylenglykol, und deren höher kondensierte Vertreter, z.B. wie Diethylenglykol, Triethylenglykol, Dipropylenglykol, Tripropylenglykol etc., Butandiol, Pentandiol, Hexandiol, Neopentylglykol, alkoxylierte phenolische Verbindungen, wie ethoxylierte bzw. propoxylierte Bisphenole, Cyclohexandimethanol, trifunktionelle und höherfunktionelle Alkohole, wie Glycerin, Trimethylolpropan, Butantriol, Trimethylolethan, Pentaerythrit, Ditrimethylolpropan, Dipentaerythrit, Sorbit, Mannit und die entsprechenden alkoxylierten, insbesondere ethoxy- und propoxylierte Alkohole.

Die Alkoxylierungsprodukte sind in bekannter Weise durch Umsetzung der vorstehenden Alkohole mit Alkylenoxiden, insbesondere Ethylen- oder Propylenoxid, erhältlich. Vorzugsweise beträgt der Alkoxylierungsgrad je Hydroxylgruppe 0 bis 10, d.h. 1 mol Hydroxylgruppe kann vorzugsweise mit bis zu 10 mol Alkylenoxiden alkoxyliert sein.

Als (Meth)acrylatverbindungen seien weiterhin Polyester(meth)acrylate genannt, wobei es sich um die (Meth)Acrylsäureester von Polyesterolen handelt.

Als Polyesterole kommen z.B. solche in Betracht, wie sie durch Veresterung von Polycarbonsäuren, vorzugsweise Dicarbonsäuren, mit Polyolen, vorzugsweise Diolen, hergestellt werden können. Die Ausgangsstoffe für solche hydroxylgruppenhaltige Polyester sind dem Fachmann bekannt. Bevorzugt können als Dicarbonsäuren Bernsteinsäure, Glutarsäure, Adipinsäure, Sebacinsäure, o-Phthalsäure, deren Isomere und Hydrierungsprodukte sowie veresterbare Derivate, wie Anhydride oder Dialkylester der genannten Säuren eingesetzt werden. Als Polyole kommen die oben genannten Alkohole, vorzugsweise Ethylenglykol, Propylenglykol-1,2 und -1,3, Butandiol-1,4, Hexandiol-1,6, Neopentylglykol, Cyclohexandimethanol sowie Polyglykole vom Typ des Ethylenglykols und Propylenglykols in Betracht.

Polyester(meth)acrylate können in mehreren Stufen oder auch einstufig, wie z.B. in EP 279 303 beschrieben, aus Acrylsäure, Polycarbonsäure und Polyol hergestellt werden.

Weiterhin kann es sich bei den Verbindungen z.B. um Epoxid- oder Urethan (meth)acrylate handeln.

Epoxid(meth)acrylate sind z.B. solche wie sie durch Umsetzung von epoxidierten Olefinen oder Poly- bzw. Mono- oder Diglycidylethern, wie Bisphenol-A-diglycidylether, mit (Meth)acrylsäure erhältlich sind.

Die Umsetzung ist dem Fachmann bekannt und z.B. in R. Holmann, U.V. and E.B. Curing Formulation for Printing Inks and Paints, London 1984, beschrieben.

Bei Urethan(meth)acrylaten handelt es sich insbesondere um Umsetzungsprodukte von Hydroxyalkyl(meth)acrylaten mit Poly- bzw. Diisocyanaten (s. ebenfalls R. Holmann, U.V. and E.B. Curing Formulation for Printing Inks and Paints, London 1984).

Es können natürlich auch Mischungen verschiedener Verbindungen B), insbesondere auch Mischungen der obigen (Meth)acrylverbindungen, eingesetzt werden.

Als strahlungshärtbare Verbindungen B) kommen z.B. auch ungesättigte Polyesterharze in Betracht, welche im wesentlichen aus Polyolen, insbesondere Diolen, und Polycarbonsäuren, insbesondere Dicarbonsäuren, bestehen, wobei eine der Veresterungskomponenten eine copolymerisierbare, ethylenisch ungesättigte Gruppe enthält. Z.B. handelt es sich dabei um Maleinsäure, Fumarsäure oder Maleinsäureanhydrid.

Bevorzugte strahlungshärtbare Verbindungen sind die Meth(acrylat)verbindungen B).

Verbindungen B) werden oft im Gemisch mit Verbindungen A), welche z.B. als Reaktivverdünner dienen, verwendet.

Bevorzugte strahlungshärtbare Massen enthalten mindestens 40 Gew.-%, besonders bevorzugt mindestens 60 Gew.-% der Verbindungen B), insbesondere der (Meth)acrylverbindungen B), bezogen auf die Gesamtmenge aus Verbindungen A)+B).

Die strahlungshärtbaren Massen enthalten vorzugsweise 0,05 bis 15, besonders bevorzugt 0,1 bis 7, ganz besonders bevorzugt 0,1 bis 5 Gew.-Teile des erfindungsgemäßen Photoinitiatormischung, bezogen auf 100 Gew.-Teile der polymerisierbaren, ethylenisch ungesättigten Verbindungen (Verbindungen A)+B)).

Die Stahlungshärtbaren Massen können auch 0,05 bis 10 Gew.-Teile der Photoinitiatormischung, bezogen auf 100 Gew.-Teile polymerisierbare, ethylenisch ungesättigte Verbindungen enthalten.

Vorteilhafterweise können die strahlungshärtbaren Massen Aminoverbindungen enthalten, welche als Beschleuniger wirken.

Es kann sich dabei um primäre, sekundäre oder tertiäre Aminverbindungen handeln. Primäre oder sekundäre Aminoverbindungen addieren sich durch eine Michael-Addition z.B. an die Doppelbindungen der (Meth)acrylverbindungen B).

Bevorzugt beträgt der Gehalt an Aminoverbindungen 0,01 bis 3 Gew.-Teile Stickstoff, besonders bevorzugt 0,05 bis 1 Gew.-Teil Stickstoff, bezogen auf 100 Gew.-Teile strahlungshärtbare Verbindungen A) + B).

Die strahlungshärtbaren Massen können z.B. Pigmente, Farbstoffe, Verlaufshilfsmittel, Stabilisatoren und weitere Photoinitiatoren enthalten. Bei pigmentierten strahlungshärtbaren Massen treten die Vorteile der erfindungsgemäßen Photoinitiatormischung besonders deutlich hervor.

Als weitere, zusätzliche Photoinitiatoren können z.B. Anthrachinon und dessen Derivate z.B. β-Methylanthrachinon oder tert.- Butylanthrachinon oder Benzoine verwendet werden.

Der Pigmentgehalt kann z.B. 5 bis 70 Gew.-Teile, vorzugsweise 10 bis 50 Gew.-Teile Pigmente, bezogen auf 100 Gew.-Teile strahlungshärtbare Verbindungen A) + B) betragen.

Die strahlungshärtbaren Massen können als Beschichtungsmassen, z.B. als Lack oder Druckfarbe oder zur Herstellung von Formkörpern, z.B. Druckplatten, Photoresisten oder Reliefformen, verwendet werden.

Des weiteren können die photopolymerisierbaren Massen als Füll- oder Spachtelmassen Verwendung finden. Für diese Verwendung sind insbesondere auch die oben genannten Massen auf Basis ungesättigter Polyester oder (Poly)Epoxid(meth)acrylate geeignet.

Eine weitere Verwendungsmöglichkeit sind Dentalmassen, z.B. als Zahnfüllmassen oder Zahnersatzkörper.

Die strahlungshärtbaren Massen werden insbesondere durch Bestrahlung mit UV-Licht gehärtet.

Als Strahlungsquellen geeignet sind z.B. Quecksilber-Niederdruckstrahlen, -Mitteldruckstrahler mit Hochdruckstrahler sowie Leuchtstoffröhren, Impulsstrahler, Metallhalogenidstrahler, Elektronenblitzeinrichtungen oder Excimerstrahler.

Die erfindungsgemäßen, strahlungshärtbaren Massen zeigen eine gute und schnelle Härtung beim Bestrahlen. Auch dicke oder pigmentierte Beschichtungen können bis in die unteren Schichten leicht ausgehärtet werden.

Die erfindungsgemäße Photoinitiatormischung führt zu keinen Geruchsbelästigungen. Sie ist im allgemeinen flüssig und daher gut zu handhaben, insbesondere leicht z.B. mit flüssigen Verbindungen A) und B) zu mischen. Besonders vorteilhaft z.B. bei der Lagerung der erfindungsgemäßen Photoinitiatormischung ist die Stabilität der Photoinitiatormischung auch bei tiefen Temperaturen von bis zu -50°C. Ein Entmischen, Auskristallisieren oder Agglomerieren sind bei diesen tiefen Temperaturen nicht zu beobachten.

### Beispiele

### I. Fotoinitiatorkonsistenz:

Die Fotoinitiatormischungen wurden bei Raumtemperatur über ca. 10 Stunden unter Rühren der Komponenten hergestellt. Die flüssigen Gemische wurden bei 5°C und -20°C gelagert und auf Stabilität, d.h. auf Änderungen der Konsistenz, wie z.B. Entmischungen und Erstarren, geprüft. Die Konsistenzänderungen würden das Verarbeiten (Abmischen, Applizieren) erschweren (zusätzlicher Aufschmelzschritt) bzw. sogar verhindern.

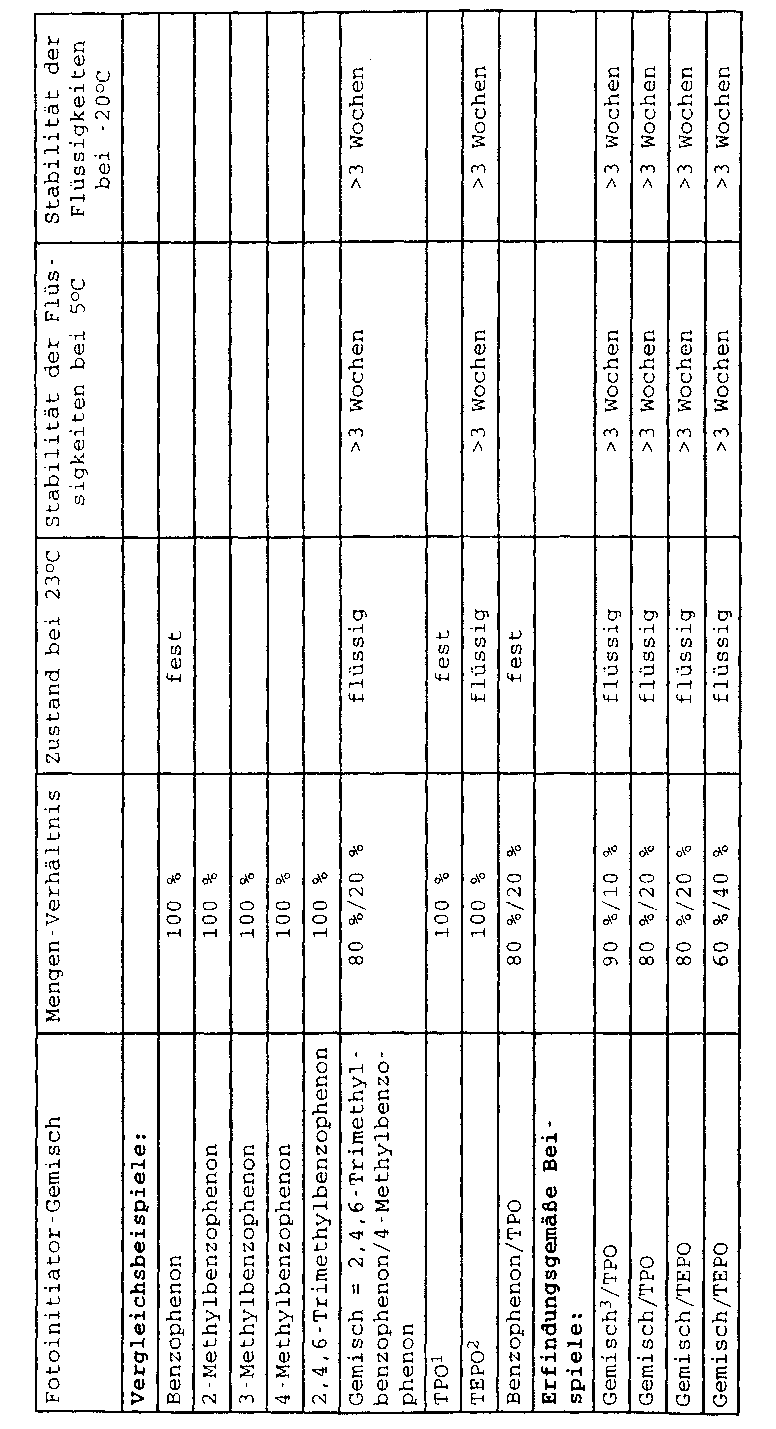

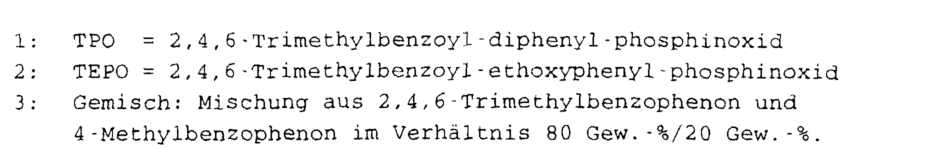

Die erfindungsgemäßen Mischungen aus Alkylbenzophenonen und Acylphosphinoxiden sind bei Raumtemperatur und auch bei tiefen Temperaturen flüssig verarbeitbar, obwohl Ausgangskomponenten selbst bei Raumtemperatur fest sind.

### II Klarlackprüfung:

Die Fotoinitiatoren wurden zu 3 Teilen mit 100 Teilen eines aminmodifizierten Polyetheracrylat (Viskosität bei 23°C: 600 mPas)
- Laromer^{®} PO 84 F (BASF AG) - abgemischt.

Geprüft werden die Härtungsgeschwindigkeit als Bandgeschwindigkeit mit der ein Flüssiglackfilm, aufgetragen auf weißem Papier, unter einer undotierten Quecksilber-Hochdrucklampe (Leistung: 120 W/cm Lampenlänge; Lampenabstand zum Substrat 12 cm) durchgefahren werden kann, um eine gegenüber dem Fingernagel kratzfeste und haftende Beschichtung zu erhalten. Die Flüssiglackfilme wurden mit einem 100 µm-Spiralrakel aufgetragen.

| Fotoinitiator-Gemisch | Mengenverhältnis | Bandgeschwindigkeit bei 100 µm Filmdicke (m/min) |
|---|---|---|
| **Vergleichsbeispiele:** | | |
| Benzophenon | 100 % | 15 |
| 2,4,6-Trimethylbenzophenon/4-Methylbenzophenon (Gemisch) | 80 %/20 % | 15 |
| TPO | 100 % | 3 |
| TEPO | 100 % | 3 |
| Benzophenon/TPO | 80:20 | 45 |
| **Erfindungsgemäße Beispiele:** | | |
| Gemisch/TPO | 80:20 | 35 |
| Gemisch/TEPO | 80:20 | 35 |

### Pigmentlackprüfung:

Die Fotoinitiatoren wurden zu 3 Teilen mit dem Gemisch aus 90 Teilen eines aminmodifizierten Polyetheracrylat (Viskosität bei 23°C: 600 mPas) - Laromer^{®} PO 84 F (BASF AG) - und 10 Teilen Anatas abgemischt. Bestimmt wurde die durchhärtbare Schichtdicke.

Dazu wurde der in ein ca. 1 cm tiefes Gefäß gefüllte Lack mit 5 m/min Bandgeschwindigkeit bestrahlt. Die gehärtete Schicht wurde mit Ethylacetat abgewaschen und deren Dicke bestimmt.

| Fotoinitiator-Gemisch | Mengenverhältnis | Durchhärtbare Schichtdicke (µm) |
|---|---|---|
| **Vergleichsbeispiele:** | | |
| Benzophenon | 100 % | 79 |
| 2,4,6-Trimethylphenon/4-Methylbenzophenon | 80:20 | 174 |
| TPO | 100 % | 294 |
| TEPO | 100 % | 301 |
| Benzophenon/TPO | 80:20 | 290 |

| **Erfindungsgemäße Beispiele:** | | |
|---|---|---|
| Gemisch/TPO | 80:20 | 298 |
| Gemisch/TEPO | 80:20 | 295 |

### Ergebnis:

Die Schichtdicken der Lacke mit den erfindungsgemäßen Fotoinitiatormischungen sind vergleichbar zu denen, die Acylphosphinoxide als Alleininitiator in größeren Anteilen enthalten und sind höher als die erreichbaren Dicken mit Benzophenonen.

### Gesamtergebnis:

Die erfindungsgemäßen Mischungen von Acylphosphinoxiden mit Alkylbenzophenonen ergeben auch bei tieferen Lagertemperaturen Flüssigmischungen, die leichter zu verarbeiten sind als Feststoffe. Eigenschaften wie Härtungsgeschwindigkeit und durchhärtbare Schichtdicke sind besser bzw. gleich denen der Ausgangskomponenten.

## Patentansprüche

1. Photoinitiatormischung, enthaltend
a) mindestens ein Acyl- oder Diacylphosphinoxid der Formel I 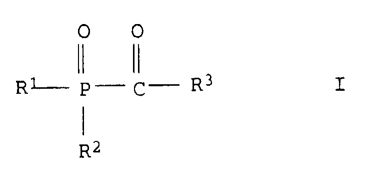 worin
R₁ C₁-C₁₈-Alkyl, durch Halogen oder C₁-C₆-Alkoxy substituiertes C₁-C₄-Alkyl, C₅-C₈-Cycloalkyl, C₇-C₉-Phenylalkyl, Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl, oder einen einwertigen N-, O- oder S-haltigen 5- oder 6-gliedrigen heterocyclischen Rest bedeutet,
R₂ Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl, einen einwertigen N-, O- oder S-haltigen 5- oder 6-gliedrigen heterocyclischen Rest, C₁-C₁₈-Alkoxy, Phenoxy, durch Halogen, C₁-C₄-Alkyl oder C₁-C₄-Alkoxy substituiertes Phenoxy, Benzyloxy, Cyclohexyloxy oder eine Gruppe -CO-R₄ bedeutet, oder R₂ und R₁ zusammen mit dem Phosphoratom einen Ring bilden,
R₃ C₁-C₁₈-Alkyl, durch Halogen oder C₁-C₆-Alkoxy substituiertes C₁-C₄-Alkyl, C₅-C₈-Cycloalkyl, C₇-C₉-Phenylalkyl, Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl, einen einwertigen N-, O- oder S-haltigen 5- oder 6-gliedrigen heterocyclischen Rest oder eine Gruppe 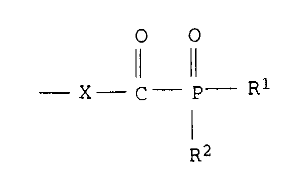 bedeutet, worin X C₂-C₈-Alkylen, Cyclohexylen oder unsubstituiertes oder durch Halogen, C₁-C₄-Alkyl oder C₁-C₄-Alkoxy substituiertes Phenylen oder Biphenylen bedeuten und
R⁴ C₁-C₁₈-Alkyl, durch Halogen oder C₁-C₄-Alkoxy substituiertes C₁-C₄-Alkyl, C₅-C₈-Cycloalkyl, C₇-C₉-Phenylalkyl, Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl oder einen einwertigen N-, O- oder S-haltigen 5- oder 6-gliedrigen heterocyclischen Rest bedeutet, oder R⁴ und R³ zusammen C₂-C₁₂-Alkylen, Vinylen oder o-Phenylen bedeuten,
und
b) mindestens ein Benzophenonderivat der Formel 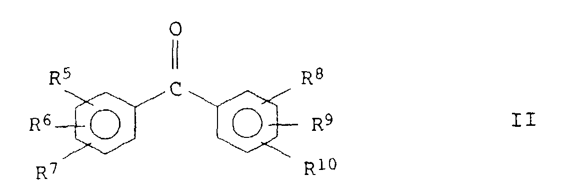 worin R⁵, R⁶ und R⁷ unabhängig voneinander C₁-C₁₂-Alkyl, C₁-C₄-Alkylthio, C₁-C₄ - Alkoxy, Halogen oder C₂-C₆-Alkoxycarbonyl bedeuten und R⁸, R⁹ und R¹⁰ Wasserstoff, C₁-C₁₂-Alkyl, C₁-C₄-Alkoxy, Halogen oder C₂-C₆-Alkoxycarbonyl oder C₁-C₄-Alkylthio bedeuten
oder ein Gemisch von Benzophenonderivaten der Formel II mit anderen Benzophenonderivaten.

2. Photoinitiatormischung gemäß Anspruch 1, wobei der Anteil der Acyl- oder Diacylphosphinoxide a) 0,5 bis 99,5 Gew.-% und der Benzophenonderivate b) 99,5 bis 0,5 Gew.-%, bezogen auf die Summe a) + b) beträgt.

3. Photoinitiatormischung gemäß Anspruch 1 oder 2, wobei es sich bei den Benzophenonderivaten b) um ein Gemisch aus Benzophenonderivaten der Formel II und Benzophenonderivaten der Formel 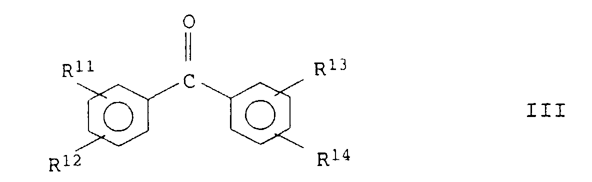 worin R¹¹, R¹², R¹³ und R¹⁴ unabhängig voneinander Wasserstoff, C₁-C₁₂-Alkyl, C₁-C₄-Alkylthio, C₁-C₄-Alkoxy, Halogen oder C₂-C₆-Alkoxycarbonyl bedeuten.

4. Photoinitiatormischung gemäß einem der Ansprüche 1 bis 3, wobei es sich bei Benzophenonderivaten b) um ein Gemisch aus 60 bis 95 Gew.-% Benzophenonderivaten der Formel II und 5 bis 40 Gew.-% Benzophenonderivaten der Formel III, bezogen auf die Gesamtmenge der Benzophenonderivate b) handelt.

5. Strahlungshärtbare Masse, enthaltend mindestens eine polymerisierbare ethylenisch ungesättigte Verbindung und eine Photoinitiatormischung gemäß einem der Ansprüche 1 bis 4.

6. Strahlungshärtbare Masse gemäß Anspruch 5, enthaltend 0,05 bis 10 Gew.-Teile der Photoinitiatormischung gemäß einem der Ansprüche 1 bis 4, bezogen auf 100 Gew.-Teile polymerisierbare, ethylenisch ungesättigte Verbindungen.

## Claims

1. A photoinitiator mixture comprising
a) at least one acyl- or diacylphosphine oxide of the formula I 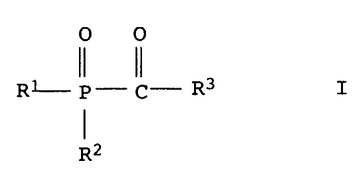 where
R¹ is C₁-C₁₈-alkyl, halogen- or C₁-C₆-alkoxy-substituted C₁-C₄-alkyl, C₅-C₈-cycloalkyl, C₇-C₉-phenylalkyl, phenyl, naphthyl, biphenylyl, mono- or poly-halogen-, -C₁-C₁₂-alkyl- and/or -C₁-C₁₂-alkoxy-substituted phenyl, naphthyl or biphenylyl, or a monovalent, N-, O- or S-containing, 5- or 6-membered heterocyclic radical,
R² is phenyl, naphthyl, biphenylyl, mono- or poly-halogen-, -C₁-C₁₂-alkyl and/or -C₁-C₁₂-alkoxy-substituted phenyl, naphthyl or biphenylyl, a monovalent, N-, O- or S-containing, 5-or 6-membered heterocyclic radical, C₁-C₁₈-alkoxy, phenoxy, halogen-, C₁-C₄-alkyl or C₁-C₄-alkoxy-substituted phenoxy, benzyloxy, cyclohexyloxy or a group -CO-R⁴, or R² and R¹ together with the phosphorus form a ring,
R³ is C₁-C₁₈-alkyl, halogen- or C₁-C₆-alkoxy-substituted C₁-C₄-alkyl, C₅-C₈-cycloalkyl, C₇-C₉-phenylalkyl, phenyl, naphthyl, biphenylyl, mono- or poly-halogen-, -C₁-C₁₂-alkyl and/or -C₁-C₁₂-alkoxy-substituted phenyl, naphthyl or biphenylyl, a monovalent N-, O- or S-containing, 5- or 6-membered heterocyclic radical or a group 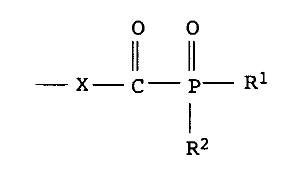 where X is C₂-C₈-alkylene, cyclohexylene or unsubstituted or halogen-, C₁-C₄-alkyl- or C₁-C₄-alkoxy-substituted phenylene or biphenylene, and
R⁴ is C₁-C₁₈-alkyl, halogen- or C₁-C₄-alkoxy-substituted C₁-C₄-alkyl, C₅-C₈-cycloalkyl, C₇-C₉-phenylalkyl, phenyl, naphthyl, biphenylyl, mono- or poly-halogen-, -C₁-C₁₂-alkyl- and/or -C₁-C₁₂-alkoxy-substituted phenyl, naphthyl or biphenylyl or a monovalent, N-, O- or S-containing, 5- or 6-membered heterocyclic radical, or R⁴ and R³ together are C₂-C₁₂-alkylene, vinylene or o-phenylene,
and
b) at least one benzophenone derivative of the formula 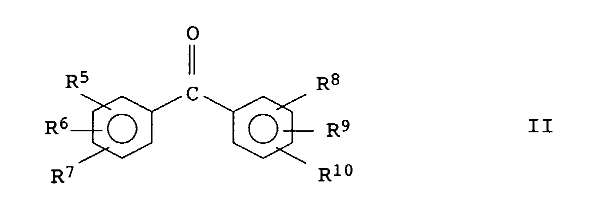 where R⁵, R⁶ and R⁷ independently are C₁-C₁₂-alkyl, C₁-C₄-alkylthio, C₁-C₄-alkoxy, halogen or C₂-C₆-alkoxycarbonyl and R⁸, R⁹ and R¹⁰ are hydrogen, C₁-C₁₂-alkyl, C₁-C₄-alkoxy, halogen or C₂-C₆-alkoxycarbonyl or C₁-C₄-alkylthio or a mixture of benzophenone derivatives of the formula II with other benzophenone derivatives.

2. A photoinitiator mixture as claimed in claim 1, where the proportion of the acyl- or diacylphosphine oxides a) is from 0.5 to 99.5 % by weight and that of the benzophenone derivatives b) is from 99.5 to 0.5 % by weight, based on the sum a) + b).

3. A photoinitiator mixture as claimed in claim 1 or 2, where the benzophenone derivatives b) are a mixture of benzophenone derivatives of the formula II and benzophenone derivatives of the formula 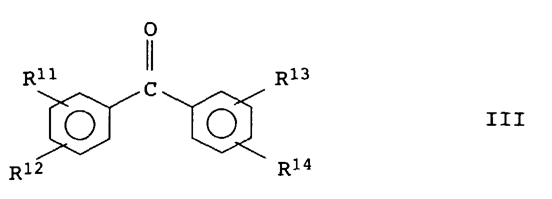 where R¹¹, R¹², R¹³ and R¹⁴ independently are hydrogen, C₁-C₁₂-alkyl, C₁-C₄-alkylthio, C₁-C₄-alkoxy, halogen or C₂-C₆-alkoxycarbonyl.

4. A photoinitiator mixture as claimed in any of claims 1 to 3, where the benzophenone derivatives b) are a mixture of from 60 to 95 % by weight of benzophenone derivatives of the formula II and from 5 to 40 % by weight of benzophenone derivatives of the formula III, based on the overall amount of benzophenone derivatives b).

5. A radiation-curable composition comprising at least one polymerizable, ethylenically unsaturated compound and a photoinitiator mixture as claimed in any of claims 1 to 4.

6. A radiation-curable composition as claimed in claim 5, comprising from 0.05 to 10 parts by weight of the photoinitiator mixture as claimed in any of claims 1 to 4, based on 100 parts by weight of polymerizable, ethylenically unsaturated compounds.

## Revendications

1. Mélange de photoamorceurs, contenant
a) au moins un oxyde d'acyl- ou diacylphosphine de formule I 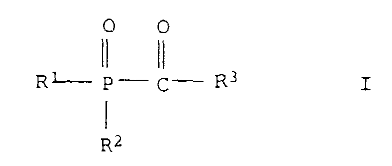 où
R¹ représente un groupement alkyle en C₁-C₁₈, un groupement alkyle en C₁-C₄ substitué par un atome d'halogène ou un groupement alcoxy en C₁-C₆, un groupement cycloalkyle en C₅-C₈, phénylalkyle en C₇-C₉, phényle, naphtyle, biphénylyle, un groupement phényle, naphtyle ou biphénylyle substitué une ou plusieurs fois par un atome d'halogène, un groupement alkyle en C₁-C₁₂, et/ou par un groupement alcoxy en C₁-C₁₂, ou bien un reste hétérocyclique monovalent à 5 ou 6 maillons et contenant du N, du O ou du S,
R² représente un groupement phényle, naphtyle, biphénylyle, un groupement phényle, naphtyle ou biphénylyle substitué une ou plusieurs fois par un atome d'halogène, un groupement alkyle en C₁-C₁₂, et/ou par un groupement alcoxy en C₁-C₁₂, ou bien un reste hétérocyclique monovalent à 5 ou 6 maillons et contenant du N, du O ou du S, un groupement alcoxy en C₁-C₁₈, phénoxy, un groupement phényloxy, benzyloxy ou cyclohexyloxy substitué par un atome d'halogène, un groupement alkyle en C₁-C₄, ou alcoxy en C₁-C₄, ou bien un groupement -CO-R⁴, ou bien R² et R¹ forment un cycle ensemble avec l'atome de phosphore
R³ représente un groupement alkyle en C₁-C₁₈, un groupement alkyle en C₁-C₄ substitué par un atome d'halogène ou un groupement alcoxy en C₁-C₆, un groupement cycloalkyle en C₅-C₈, phénylalkyle en C₇-C₉, phényle, naphtyle, biphénylyle, un groupement phényle, naphtyle ou biphénylyle substitué une ou plusieurs fois par un atome d'halogène, un groupement alkyle en C₁-C₁₂, et/ou par un groupement alcoxy en C₁-C₁₂, un reste hétérocyclique monovalent à 5 ou 6 maillons et contenant du N, du O ou du S ou un groupement 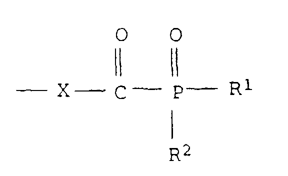 où X représente un groupement alkylène en C₂-C₈, cyclohexylène ou bien un groupement phénylène ou biphénylène non substitués ou substitués par un atome d'halogène, un groupement alkyle en C₁-C₄, ou alcoxy en C₁-C₄, et
R⁴ représente un groupement alkyle en C₁-C₁₈, un groupement alkyle en C₁-C₄ substitué par un atome d'halogène ou un groupement alcoxy en C₁-C₄, un groupement cycloalkyle en C₅-C₈, phénylalkyle en C₇-C₉, phényle, naphtyle, biphénylyle, un groupement phényle, naphtyle ou biphénylyle substitué une ou plusieurs fois par un atome d'halogène, un groupement alkyle en C₁-C₁₂, et/ou par un groupement alcoxy en C₁-C₁₂, ou bien un reste hétérocyclique monovalent à 5 ou 6 maillons et contenant du N, du O ou du S, ou bien R⁴ et R³ représentent ensemble un groupement alkylène en C₂-C₁₂, vinylène ou o-phénylène,
et
b) au moins un dérivé de benzophénone de formule 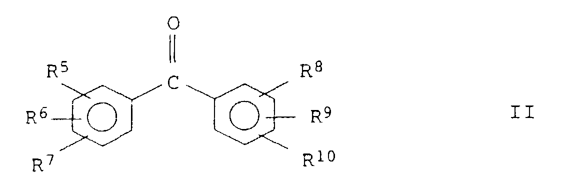 où R⁵, R⁶ et R⁷ représentent indépendamment les uns des autres, un groupement alkyle en C₁-C₁₂, alkylthio en C₁-C₄, alcoxy en C₁-C₄, un atome d'halogène ou un groupement alcoxycarbonyle en C₂-C₆, et R⁸, R⁹ et R¹⁰ représentent un atome d'hydrogène, un groupement alkyle en C₁-C₁₂, alcoxy en C₁-C₄, un atome d'halogène ou un groupement alcoxycarbonyle en C₂-C₆ ou alkylthio en C₁-C₄,
ou un mélange de dérivés de benzophénone de formule II avec d'autres dérivés de benzophénone.

2. Mélange de photoamorceurs selon la revendication 1, où la proportion d'oxyde d'acyl- ou diacylphosphines a) s'élève à 0,5-99,5% en poids et celle du dérivé de benzophénone b) à 99,5-0,5% en poids, par rapport à la somme a) + b).

3. Mélange de photoamorceurs selon la revendication 1 ou 2, où les dérivés de benzophénone b) sont un mélange de dérivés de benzophénone de formule II et de dérivés de benzophénone de formule 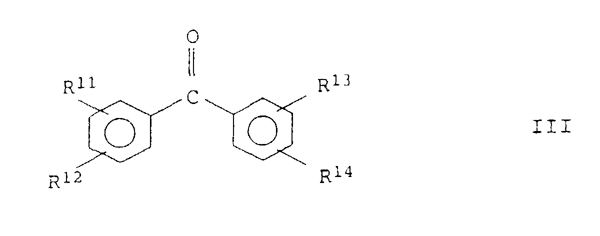 où R¹¹, R¹² R¹³ et R¹⁴ représentent indépendamment les uns des autres, un atome d'hydrogène, un groupement alkyle en C₁-C₁₂, alkylthio en C₁-C₄, alcoxy en C₁-C₄, un atome d'halogène ou un groupement alcoxycarbonyle en C₂-C₆.

4. Mélange de photoamorceurs selon l'une quelconque des revendications 1 à 3, où les dérivés de benzophénone b) sont un mélange de 60 à 95% en poids de dérivés de benzophénone de formule II et de 5 à 40% en poids de dérivés de benzophénone de formule III, par rapport à la quantité totale des dérivés de benzophénone b).

5. Masse durcissable par rayonnement, contenant au moins un composé à insaturation éthylénique polymérisable et un mélange de photoamorceurs selon l'une quelconque des revendications 1 à 4.

6. Masse durcissable par rayonnement selon la revendication 5, contenant 0,05 à 10 parties en poids du mélange de photoamorceurs selon l'une quelconque des revendications 1 à 4, par rapport à 100 parties en poids de composés à insaturation éthylénique polymérisables.
